Europäisches Patentamt

European Patent Office

Office européen des brevets

(19)

(11) **EP 0 463 919 B1**

(12) **FASCICULE DE BREVET EUROPEEN**

(45) Date de publication et mention
de la délivrance du brevet:
**12.11.1997 Bulletin 1997/46**

(51) Int Cl.6: **G01R 33/24**

(21) Numéro de dépôt: **91401596.1**

(22) Date de dépôt: **14.06.1991**

(54) **Magnétomètre directionnel à résonance**

Resonanz- und Richtungsmagnetometer

Directional resonance magnetometer

(84) Etats contractants désignés:
**CH DE DK FR GB IT LI**

(30) Priorité: **25.06.1990 FR 9007946**

(43) Date de publication de la demande:
**02.01.1992 Bulletin 1992/01**

(73) Titulaire: **COMMISSARIAT A L'ENERGIE
ATOMIQUE
75015 Paris (FR)**

(72) Inventeurs:
• **Duret, Denis
F-38100 Grenoble (FR)**
• **Beranger, Marc
F-38240 Meylan (FR)**

(74) Mandataire: **Dubois-Chabert, Guy et al
Société de Protection des Inventions
25, rue de Ponthieu
75008 Paris (FR)**

(56) Documents cités:
**EP-A- 0 240 221      EP-A- 0 359 598
DD-A- 273 129        GB-A- 1 551 236
US-A- 4 623 844      US-A- 4 814 707**

• **IEEE TRANSACTIONS ON INSTRUMENTATION
AND MEASUREMENT, vol. 38, no. 2, avril 1989,
New York US, pages 410-414; K. WEYAND : "An
NMR marginal oscillator for measuring magnetic
fields below 50 mT"**

## Description

La présente invention concerne un magnétomètre directionnel à résonance.

Ce magnétomètre est plus particulièrement destiné à la mesure de champs magnétiques faibles, de l'ordre de 0 à 100 microteslas par exemple.

La présente invention trouve donc des applications en particulier en géophysique, en prospection minière et en détection spatiale.

Le magnétomètre objet de l'invention est directionnel, c'est-à-dire qu'il est associé à une direction de mesure et que le magnétomètre permet en fait de déterminer la valeur de la projection d'un champ magnétique, grandeur vectorielle, sur cette direction de mesure.

La bande passante de ce genre de magnétomètre va de 0 Hz à 10 Hz et peut même aller jusqu'à plusieurs kHz.

L'expression de la résolution du magnétomètre doit tenir compte de plusieurs paramètres :

a) la densité spectrale de bruit ramené à l'entrée, cette densité étant une fonction de la fréquence f de mesure dans le cas général et s'exprimant en $nT.Hz^{-1/2}$,

b) l'existence d'un bruit en $f^{-a}$, qui croît en général aux basses fréquences,

c) la dérive au cours du temps et en fonction de la température, et

d) la stabilité du zéro avec présence ou non d'un faux zéro.

On connaît déjà des magnétomètres directionnels de type "flux gate", dont une bonne description est donnée dans le document (1) qui, comme les autres documents cités par la suite, est mentionné à la fin de la présente description.

Le bruit-limite de tels magnétomètres de type "flux gate" est de l'ordre de 10pT.

Les effets de stabilité de zéro existent dans de tels magnétomètres qui, par ailleurs, sont très performants mais coûteux.

De plus, le fait de soumettre un magnétomètre de ce type à de forts champs magnétiques, à des chocs ou encore à des pressions, peut avoir des effets très néfastes sur ses caractéristiques.

On connaît aussi des magnétomètres directionnels à résonance par les documents (2), (3) et (4).

Les magnétomètres directionnels de type "flux gate" et les magnétomètres directionnels à résonance connus présentent des inconvénients mentionnés ci-après.

Les magnétomètres de type "flux gate" présentent des dérives au cours du temps et en fonction de la température ; ils sont sujets au phénomène de faux zéro (c'est-à-dire qu'ils donnent une réponse non nécessairement nulle en présence d'un champ magnétique nul) et sont sensibles de manière irréversible aux forts champs magnétiques, aux chocs et aux pressions.

Les magnétomètres directionnels à résonance connus sont, quant à eux, encombrants (leur volume peut atteindre plusieurs $dm^3$) et ont une faible résolution, de l'ordre de 1nT.

La présente invention propose un magnétomètre directionnel à résonance dont les performances sont analogues à celles des magnétomètres de type "flux gate" tout en ayant des dérives thermique et temporelle limitées, qui n'est pas sujet au phénomène de faux zéro et dont la sensibilité aux champs magnétiques forts, aux chocs et à la pression est réversible.

De plus, la taille du magnétomètre objet de la présente invention peut être réduite à une valeur de l'ordre de quelques millimètres.

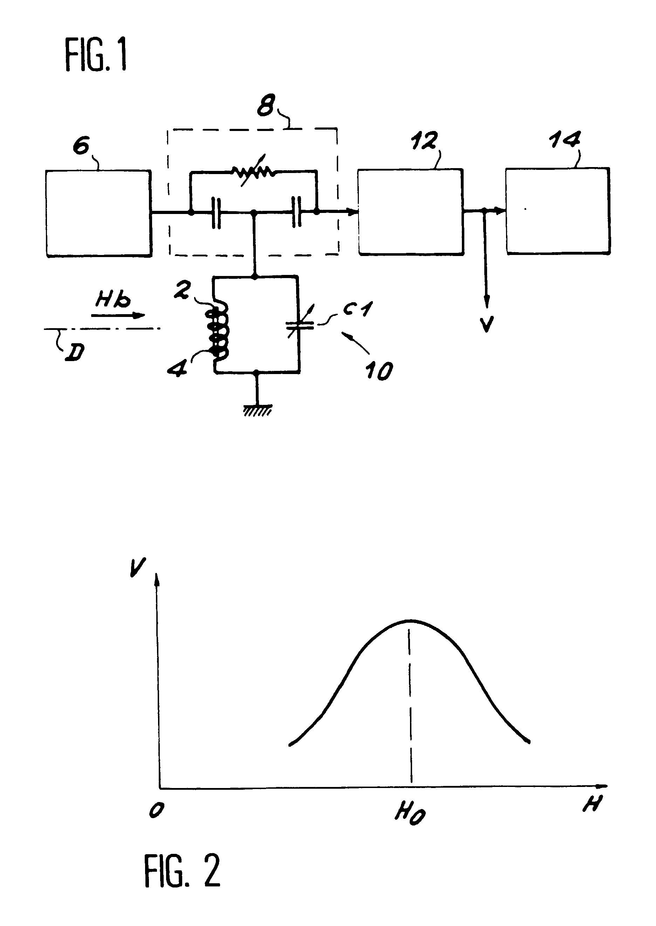

On rappelle ci-après et en se référant aux figures 1 à 6, divers dispositifs connus dans le domaine de la magnétométrie ou de la spectrométrie.

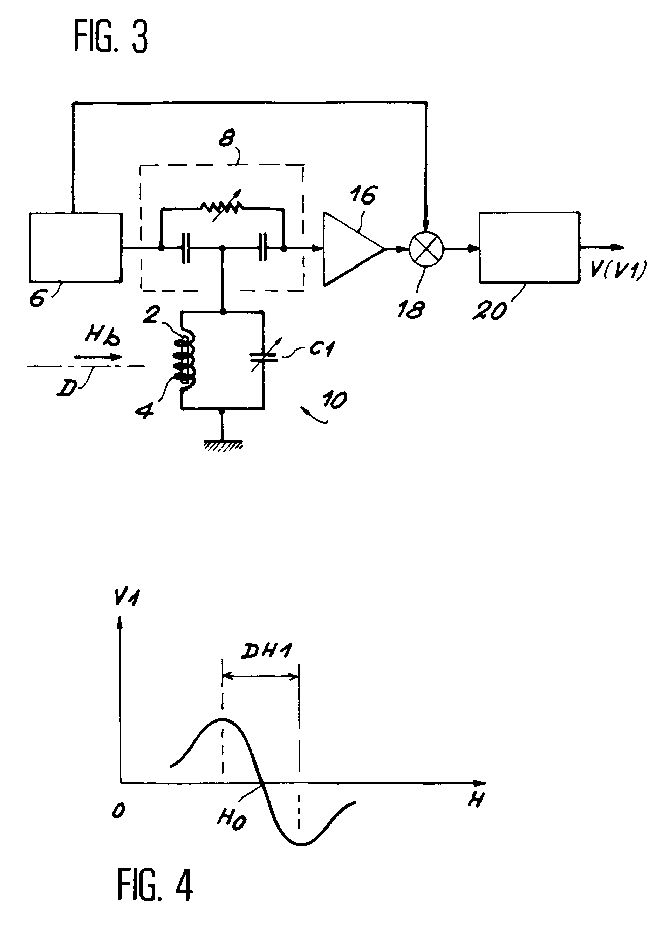

Sur la figure 1, on a représenté schématiquement un magnétomètre connu par le document (3) (voir la figure 4 de ce document (3)).

Dans ce magnétomètre, un échantillon 2 fait d'un matériau possédant des spins électroniques résonants est soumis à un champ magnétique de polarisation Hb ainsi qu'à un champ magnétique extérieur à mesurer Hex, ce dernier étant par exemple le champ magnétique terrestre.

Le champ de polarisation Hb est créé par tout moyen approprié, par exemple une bobine magnétique (non représentée) qui est placée au voisinage de l'échantillon et qui est alimentée par un courant électrique dont l'intensité est variable.

Le magnétomètre de la figure 1 comprend aussi une bobine d'excitation et de réception 4 qui entoure l'échantillon 2.

L'axe de la bobine 4 est perpendiculaire à la direction D du champ de polarisation Hb.

Cette direction du champ Hb est la direction de mesure du magnétomètre de la figure 1.

Dans le cas où les spins électroniques résonnent, la fréquence fo de résonance de ces spins électroniques est donnée par la relation de Larmor :

$$fo = g.Mo.Ho/(2pi)$$

avec

Mo =  $4 pi.10^{-7}$ H/m

g :  rapport gyromagnétique de l'électron (g/2pi = 28 GHz/T)

Ho :  champ magnétique appliqué aux spins à la résonance (exprimé en A/m)

pi :  nombre bien connu qui vaut approximativement 3,1416.

Un générateur 6 de haute fréquence, réglé sur fo, excite la résonance par l'intermédiaire d'un pont de mesure 8 et de la bobine 4 qui fait partie d'un circuit résonant 10, ce dernier étant accordé à la fréquence fo et comprenant, en plus de la bobine 4, un condensateur variable c1 monté entre les bornes de la bobine 4.

La résonance est détectée par l'intermédiaire de la bobine 4, du pont de mesure 8 et d'un récepteur 12 qui possède une détection d'amplitude.

Le pont de mesure 8 a pour fonction de découpler la réception de l'excitation.

On remarquera que ce pont de mesure 8 peut être supprimé à condition de prévoir une bobine émettrice à la fois orthogonale à la direction D et à l'axe de la bobine 4, reliée au générateur 6, le circuit résonant 10 étant dans ce cas seulement relié au récepteur 12.

Un dispositif d'observation 14 reçoit en entrée une tension détectée V fournie par la sortie du récepteur 12.

Le dispositif 14 fournit une courbe que l'on voit sur la figure 2 et qui représente les variations de la tension V en fonction du champ magnétique H appliqué aux spins électroniques.

Il s'agit d'une courbe d'absorption dont la forme est gaussienne.

La résonance a lieu lorsque H est égal à Ho.

Le champ appliqué H est la somme vectorielle du champ de polarisation Hb et du champ extérieur à mesurer Hex.

On choisit un champ Ho très supérieur au champ Hex de sorte que H s'exprime approximativement par la formule suivante :

$$H = Hb + (Hex.cosTh)$$

dans laquelle Th est l'angle entre les vecteurs qui représentent Hb et Hex, ce qui confirme le caractère directionnel du magnétomètre.

On notera que la formule ci-dessus permet de déterminer Hex, connaissant Th, Ho et la valeur Hbo de Hb qui conduit à Ho.

Outre l'obtention de cette formule simple, un autre intérêt de choisir Ho très important réside dans le fait que le rapport signal/bruit du magnétomètre est, en première approximation, proportionnel à $fo^2$ et donc à $Ho^2$.

Sur les figures 1 à 3 du document (3) sont représentées des variantes de réalisation du magnétomètre schématiquement représenté sur la figure 1 annexée à la présente description.

Un dispositif connu par le document (5) dans le domaine de la spectrométrie mais non utilisé dans le domaine de la magnétométrie est schématiquement représenté sur la figure 3 et met en oeuvre une détection cohérente de la haute fréquence.

Le dispositif de la figure 3 utilise l'échantillon 2, le champ Hb, la bobine 4, le générateur 6, le pont de mesure 8 et le circuit résonant 10 de la figure 1, agencés de la même façon, et comprend en outre un amplificateur à faible bruit 16, un mélangeur équilibré 18 et un filtre passe-bas 20.

Le signal de haute fréquence qui est disponible à la sortie du pont de mesure 8, est amplifié par l'amplificateur 16 et envoyé à l'entrée du mélangeur équilibré 18 dont le signal de référence est une "image" de l'excitation de haute fréquence.

Plus précisément, ce signal de référence est un signal qui a la même fréquence que celle du signal d'excitation envoyé par le générateur 6 au pont de mesure 8 mais dont l'amplitude et la phase peuvent être rendues différentes de celles de ce dernier signal.

La sortie du mélangeur 18 est filtrée par le filtre passe-bas 20 pour éliminer les résidus ainsi que des harmoniques de la haute fréquence.

En montant à la sortie du filtre passe-bas 20 un dispositif d'observation approprié non représenté, on peut alors obtenir, suivant les phases respectives du signal d'excitation et du signal de référence, la courbe de la figure 2 ou la courbe de la figure 4 qui représente les variations d'une tension V1 en fonction du champ H et qui est appelée courbe de dispersion.

Cette courbe de la figure 4 peut être utilisée telle quelle pour un magnétomètre, avec des limites en linéarité et en dérives, ou comme signal de zéro dans un dispositif d'asservissement de champ magnétique.

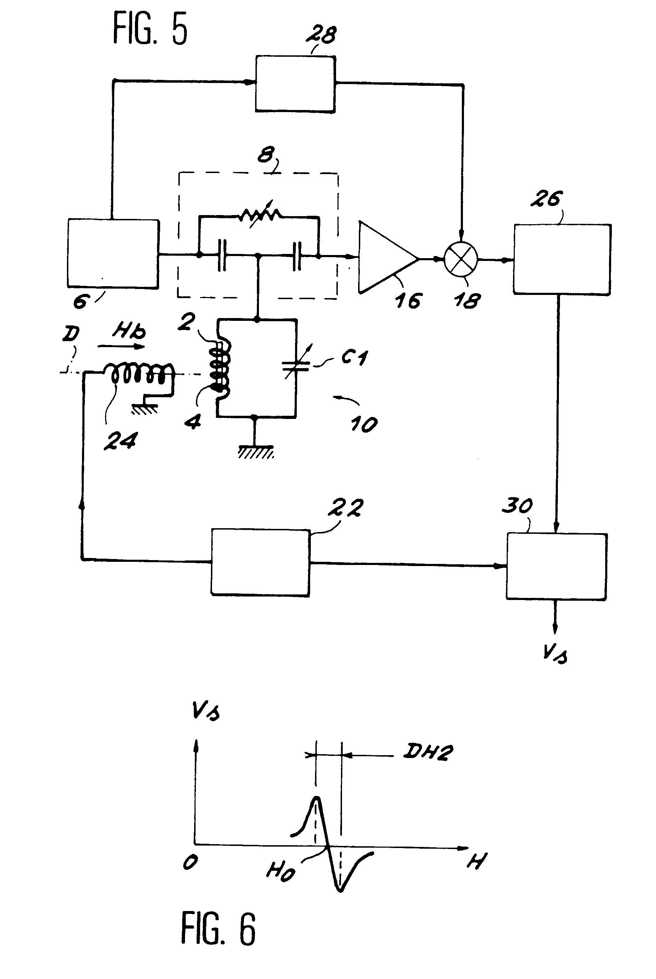

Un autre dispositif connu dans le domaine de la spectrométrie et utilisé dans le domaine de la magnétométrie est schématiquement représenté sur la figure 5.

Cet autre dispositif permet d'obtenir la dérivée de la courbe d'absorption.

Le dispositif de la figure 5 utilise l'échantillon 2, le champ Hb, la bobine 4, le générateur 6, le pont de mesure 8, le circuit résonant 10, l'amplificateur 16 et le mélangeur équilibré 18 de la figure 3, agencés de la même façon.

Ce dispositif de la figure 5 comprend en outre un oscillateur 22, qui engendre un signal ayant une fréquence-audio notée fm, et une bobine 24 qui reçoit ce signal et qui crée dans l'échantillon 2 un champ magnétique de fréquence fm, appelé "champ d'agitation" et superposé au champ Hb, l'axe de la bobine 24 étant confondu avec l'axe de la bobine (non représentée) qui sert à créer le champ Hb.

A la sortie du mélangeur équilibré 18, le filtre passe-bas 20 de la figure 3 est remplacé par un filtre passe-bande 26 autour de la fréquence fm.

Un déphaseur 28 reçoit le signal de haute fréquence issu du générateur 6 et fournit au mélangeur équilibré 18 un signal de phase adéquate pour obtenir, à la sortie de ce mélangeur 18, la tension V de la courbe représentée sur la figure 2.

Un moyen de détection synchrone 30 à la fréquence fm, qui est commandé par un signal de référence issu de l'oscillateur 22, a son entrée reliée à la sortie du filtre 26 et fournit en sortie une tension Vs.

Ce signal de référence a une fréquence fm mais son amplitude et sa phase peuvent être rendues différentes de celles du signal fourni par l'oscillateur 22 à la bobine 24.

En montant à la sortie du moyen de détection synchrone 30 un moyen d'observation approprié (non représenté), on peut observer une courbe que l'on voit sur la figure 6, sans tension de décalage.

Cette courbe représente les variations de la tension Vs en fonction du champ H et constitue la dérivée de la courbe de la figure 2.

Les paramètres permettant d'optimiser les matériaux résonants et les amplitudes respectives du champ de haute fréquence et du champ d'agitation sont obtenus par un procédé qui est décrit dans le document (5).

On a donc vu qu'il était connu de réaliser un magnétomètre directionnel à l'aide des moyens suivants : un échantillon fait d'un matériau résonant approprié (voir par exemple le document (6) à ce sujet), une ou plusieurs bobines de prélèvement et d'excitation, un dispositif permettant de créer un champ de polarisation continu Hb (proche de Ho), un oscillateur à la résonance, et un moyen électronique permettant d'obtenir la courbe de la figure 4 ou de la figure 6.

Dans ce cas, une variation du champ extérieur Hex, dans la mesure où elle est très inférieure à la largeur de raie DH1 (courbe de la figure 4) ou DH2 (courbe de la figure 6), se traduit par un écart à la résonance et par une tension-image en sortie du magnétomètre.

La linéarité peut être améliorée par une contre-réaction de champ en se servant de la tension V1 (figure 4) ou de la tension Vs (figure 6) en tant qu'indicateur de zéro, en intégrant cette tension et en réinjectant un courant qui lui est proportionnel et qui crée un champ magnétique grâce à une bobine dont l'axe est parallèle à la direction de Hb.

Une telle façon de faire est courante en magnétométrie (voir le document (7)).

L'inconvénient principal de ce type de magnétomètre est lié à la stabilité du champ de polarisation Hb.

La précision requise peut être évaluée à l'aide d'un exemple simple, donné ci-après.

On considère un champ à mesurer Hex de 50 microteslas, avec une précision de 10 pT, et un champ de polarisation Hb cent fois plus important que Hex, soit un champ Hb de 5 mT.

Toute variation de Hb sera interprétée comme une variation de Hex.

Le champ Hb doit donc être stable à 10 pT prés, soit $2.10^9$ en précision relative.

Un tel objectif est quasiment impossible à atteindre avec les techniques connues.

Une solution, qui a cependant été essayée, consiste à pulser le champ Hb à une fréquence fp très inférieure à fo pour que ce champ Hb décrive alternativement la raie de résonance en plus et en moins (voir les documents (2), (3) et (4)).

Le problème de stabilité à résoudre se ramène alors à l'obtention d'une stabilité à court terme, sur une période de 1/fp.

Le problème lié à la solution ci-dessus est que la résonance n'est pas exploitée dans sa zone de sensibilité maximale (voir document (5)) si ce n'est pendant une fraction infime du temps de balayage 1/fp, ce balayage etant de type sinusoïdal ou triangulaire.

La présente invention a pour but de remédier à tous les inconvénients mentionnés précédemment en proposant un magnétomètre directionnel à résonance qui, entre autres, ne présente pas de dérives liées au temps ou à la température et a une meilleure résolution que les magnétomètres directionnels à résonance connus.

On connaît aussi par GB-A-1551236 un appareil de mesure de l'intensité d'un courant électrique. Cet appareil comprend deux cellules à résonance magnétique nucléaire, des moyens pour engendrer, dans les deux cellules, des champs magnétiques de polarisation parallèle, de même sens et de même amplitude, des moyens permettant d'engendrer des champs d'épreuve qui sont parallèles et ont la même amplitude mais des sens respectivement identique et opposé à ceux des champs de polarisation ainsi que des moyens pour exciter magnétiquement chaque cellule à sa propre fréquence de Larmor et des moyens permettant d'obtenir un signal résultant fonction de la différence entre les fréquences de Larmor des cellules.

De facon précise, la présente invention a pour objet un magnétomètre directionnel à résonance, destiné à mesurer un champ magnétique H1ex qui est la projection, sur une direction déterminée, d'un champ magnétique Hex, ce magnétométre comprenant :

- un échantillon fait d'un matériau comportant des spins résonants,
- des premiers moyens magnétiques placés au voisinage de l'échantillon et prévus pour exciter la résonance des spins et pour détecter la résonance excitée, et
- des deuxièmes moyens magnétiques placés au voisinage de l'échantillon et prévus pour engendrer un champ magnétique de polarisation Hb suivant la direction déterminée et pour compenser le champ H1ex,

magnétométre caractérisé en ce qu'il comprend en outre :

- des moyens de traitement et d'asservissement qui sont reliés aux premiers moyens magnétiques et aux deuxièmes moyens magnétiques et servent à obtenir des valeurs de tensions respectivement proportionnelles à (Hb-Ho+H1ex) et à (Ho-Hb+H1ex) au voisinage de la résonance, Ho étant la valeur du champ magnétique appliqué à l'échantillon à la résonance et étant très supérieur à Hex (c'est-à-dire au moins égal à environ 10 fois Hex), et un courant pulsé en créneaux permettant d'induire le champ Hb par l'intermédiaire des deuxièmes moyens magnétiques, et de fournir une tension Vmes proportionnelle à ce champ H1ex en particulier aux deuxièmes moyens magnétiques.

Selon un mode de réalisaticn préféré de l'invention, les moyens de traitement et d'asservissement comprennent :

- des moyens de traitement reliés aux premiers moyens magnétiques et aux deuxièmes moyens magnétiques et permettant d'obtenir d'une part des valeurs de tensions respectivement proportionnelles à (Hb-Ho+H1ex) et à (Ho-Hb+H1ex) au voisinage de la résonance, Ho étant la valeur du champ magnétique appliqué à l'échantillon à la résonance et étant très supérieur à Hex (c'est-à-dire au moins égal à environ 10 fois Hex), et d'autre part un courant pulsé en créneaux permettant d'induire le champ Hb par l'intermédiaire des deuxièmes moyens magnétiques, et
- des moyens d'asservissement qui sont reliés d'une part aux moyens de traitement et d'autre part aux deuxièmes moyens magnétiques pour compenser le champ H1ex, et qui fournissent une tension proportionnelle à ce champ H1ex.

Les moyens d'asservissement peuvent comprendre un intégrateur, qui est commandé par les moyens d'asservissement, et un convertisseur tension-courant dont l'entrée est reliée à la sortie de l'intégrateur et dont la sortie alimente les deuxièmes moyens magnétiques.

Selon un premier mode de réalisation particulier du magnétomètre objet de l'invention, les moyens de traitement comprennent :

- des moyens électroniques prévus pour alimenter les premiers moyens magnétiques par un courant à la fréquence de Larmor correspondant à Ho et pour fournir en sortie un signal de tension dont les variations en fonction du champ magnétique appliqué à l'échantillon correspondent à la courbe de dispersion de cet échantillon,
- un premier dispositif électronique relié à la sortie des moyens électroniques et permettant un gain en tension valant alternativement +1 et -1,
- un échantillonneur-bloqueur dont l'entrée est reliée à la sortie du premier dispositif électronique et dont la sortie commande les moyens d'asservissement,
- une source de tension électrique,
- un deuxième dispositif électronique alimenté par cette source et permettant un gain en tension valant alternativement +1 et -1, et
- un autre convertisseur tension-courant dont l'entrée est reliée à la sortie du deuxième dispositif électronique et qui alimente les deuxièmes moyens magnétiques.

Selon un deuxième mode de réalisation particulier qui, contrairement au premier, utilise une détection synchrone, les moyens de traitement comprennent :

- des moyens électroniques prévus pour alimenter les premiers moyens magnétiques par un courant à la fréquence de Larmor correspondant à Ho et pour fournir en sortie, grâce à une détection synchrone commandée par un signal de tension à une fréquence audio, un signal de tension dont les variations en fonction du champ magnétique appliqué à l'échantillon correspondent à la dérivée de la courbe d'absorption de cet échantillon,
- un premier dispositif électronique relié à la sortie des moyens électroniques et permettant un gain en tension valant alternativement +1 et -1,
- un échantillonneur-bloqueur dont l'entrée est reliée à la sortie du premier dispositif électronique et dont la sortie commande les moyens d'asservissement,
- une source de tension électrique,
- un deuxième dispositif électronique alimenté par cette source et permettant un gain en tension valant alternativement +1 et -1, et
- un autre convertisseur tension-courant dont l'entrée est reliée à la sortie du deuxième dispositif électronique et qui alimente les deuxièmes moyens magnétiques.

Selon un troisième mode de réalisation particulier, qui utilise également une détection synchrone, les moyens de traitement comprennent :

- des moyens électroniques prévus pour alimenter les premiers moyens magnétiques par un courant à la fréquence de Larmor correspondant à Ho et pour fournir en sortie, grâce à une détection synchrone commandée par un signal de tension à une fréquence audio, un signal de tension dont les variations en fonction du champ magnétique appliqué à l'échantillon correspondent à la dérivée de la courbe d'absorption de de cet échantillon,
- un échantillonneur-bloqueur dont l'entrée est reliée à la sortie des moyens électroniques et dont la sortie commande les moyens d'asservissement,
- une source de tension électrique,
- un moyen de sommation prévu pour fournir en sortie un signal de tension égal à la somme de cette tension et du signal à fréquence audio,
- un dispositif électronique relié à la sortie du moyen de sommation et permettant un gain en tension valant alternativement +1 et -1, et
- un autre convertisseur tension-courant dont l'entrée est reliée à la sortie du dispositif électronique et qui alimente les deuxièmes moyens magnétiques.

La présente invention sera mieux comprise à la lecture de la description d'exemples de réalisation donnés ci-après à titre purement indicatif et nullement limitatif, en référence aux dessins annexés sur lesquels :

- la figure 1, déjà décrite, représente schématiquement un magnétomètre directionnel à résonance connu,

- la figure 2, déjà décrite, représente une courbe d'absorption que l'on peut obtenir avec le magnétomètre représenté sur la figure 1,
- la figure 3, déjà décrite, représente schématiquement un dispositif de spectrométrie connu,
- la figure 4, déjà décrite, représente une courbe de dispersion que l'on peut obtenir avec le dispositif de la figure 3,
- la figure 5, déjà décrite, représente un autre magnétomètre directionnel à résonance connu,
- la figure 6, déjà décrite, représente la courbe qui est la dérivée de la courbe de la figure 2 et que l'on peut obtenir avec le magnétomètre de la figure 5,
- la figure 7 est une vue schématique d'un mode de réalisation particulier du magnétomètre objet de l'invention, qui n'utilise pas de détection synchrone,
- la figure 8 est en vue schématique d'un autre mode de réalisation particulier du magnétomètre objet de l'invention, qui utilise une détection synchrone,
- la figure 9 illustre schématiquement un dispositif électronique utilisé dans les magnétomètres représentés sur les figures 7 et 8,
- la figure 10 est un chronogramme montrant des signaux d'horloge utilisés dans les magnétomètres représentés sur les figures 7 et 8,
- la figure 11 représente des courbes champ magnétique-tension et temps-champ magnétique qui illustrent le fonctionnement des magnétomètres représentés sur les figures 7 et 8,
- la figure 12 est un autre chronogramme qui illustre également le fonctionnement des magnétomètres représentés sur les figures 7 et 8,
- la figure 13 illustre schématiquement et partiellement une variante de réalisation du magnétomètre représenté sur la figure 8, et
- les figures 14 à 22 illustrent schématiquement diverses variantes de réalisation des magnétomètres des figures 7 et 8.

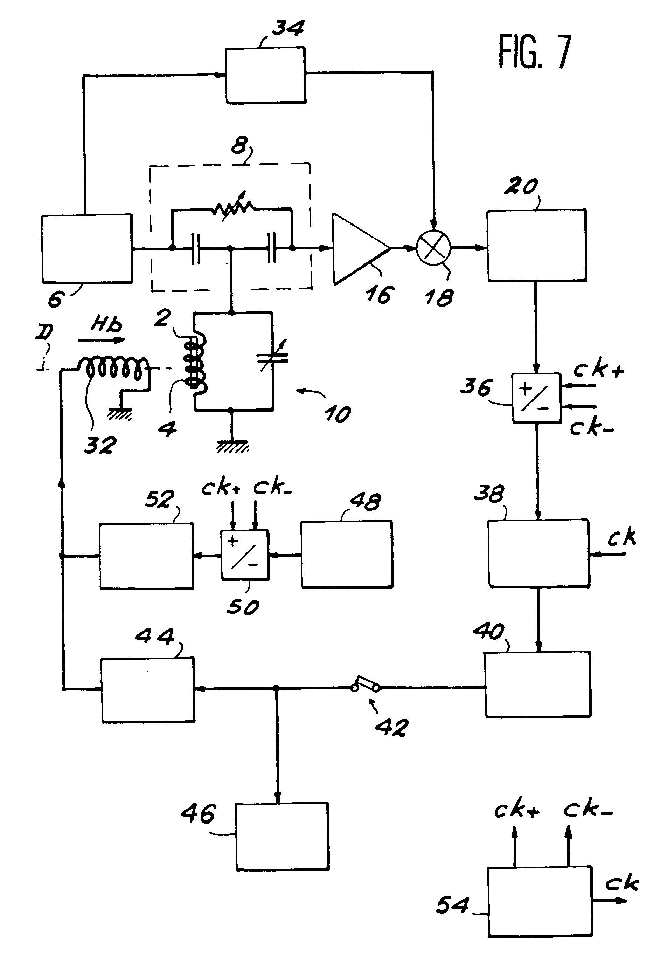

Le magnétomètre directionnel à résonance conforme à la présente invention, qui est schématiquement représenté sur la figure 7 comprend l'ensemble des éléments référencés 2, 4, 6, 8, 10, 16, 18 et 20 sur la figure 3 et agencés de la même façon que sur cette figure 3.

L'échantillon utilisable dans la présente invention, en particulier dans les magnétomètres des figures annexées, est par exemple l'un de ceux qui sont décrits aux pages 3 et 4 du document (6).

Dans le cas de la figure 7, le champ de polarisation noté Hb, de direction D, est créé par une bobine qui porte la référence 32, dont l'axe est perpendiculaire à celui de la bobine 4 et qui est alimentée d'une manière expliquée par la suite.

L'ensemble en question comporte en outre un déphaseur 34 par l'intermédiaire duquel le signal de haute fréquence fo du générateur 6 est fourni au mélangeur équilibré 18 et qui est réglé de façon à déphaser ce signal de telle manière que le filtre passe-bas 20 fournisse en sortie la tension V1 dont les variations en fonction du champ appliqué à l'échantillon 2 sont représentées par la courbe de dispersion de la figure 4.

Le magnétomètre de la figure 7 comprend aussi un dispositif électronique 36, un échantillonneur-bloqueur 38 et un intégrateur 40 qui sont montés à la suite du filtre 20 et dans cet ordre.

La sortie de l'intégrateur 40 est reliée, par l'intermédiaire d'un interrupteur 42 (à deux positions ouvert-fermé), à l'entrée d'un convertisseur tension-courant 44 dont la sortie alimente la bobine 32.

A la sortie de l'interrupteur 42, qui est fermé lors du fonctionnement du magnétomètre de la figure 7, sont montés des moyens d'affichage 46 permettant d'afficher la tension de sortie de l'intégrateur 40.

Le magnétomètre de la figure 7 comprend aussi une source de tension préférentiellement stable et réglable 48 qui permet, par l'intermédiaire d'un dispositif 50, identique au dispositif 36, et d'un convertisseur 52, d'injecter un courant stable dans la bobine 32, cette dernière créant ainsi le champ Hb correspondant approximativement à la fréquence fo.

Chacun des convertisseurs 44 et 52 est par exemple une résistance électrique.

Chacun des dispositifs 36 et 50 est un dispositif électronique commandé par des signaux d'horloge impulsionnels ck+ et ck- et permettant un gain en tension qui vaut +1 lorsque ce dispositif reçoit un signal d'horloge ck+ et -1 lorsqu'il reçoit un signal d'horloge ck-.

L'échantillonneur-bloqueur 38 est par exemple du genre du circuit AD585 de la société Analog Device ; il est commandé par des signaux d'horloge impulsionnels ck pendant lesquels il "suit" le signal qui lui arrive en entrée et entre lesquels il mémorise ce signal.

Les signaux d'horloge ck, ck+ et ck- sont définis par des tensions positives.

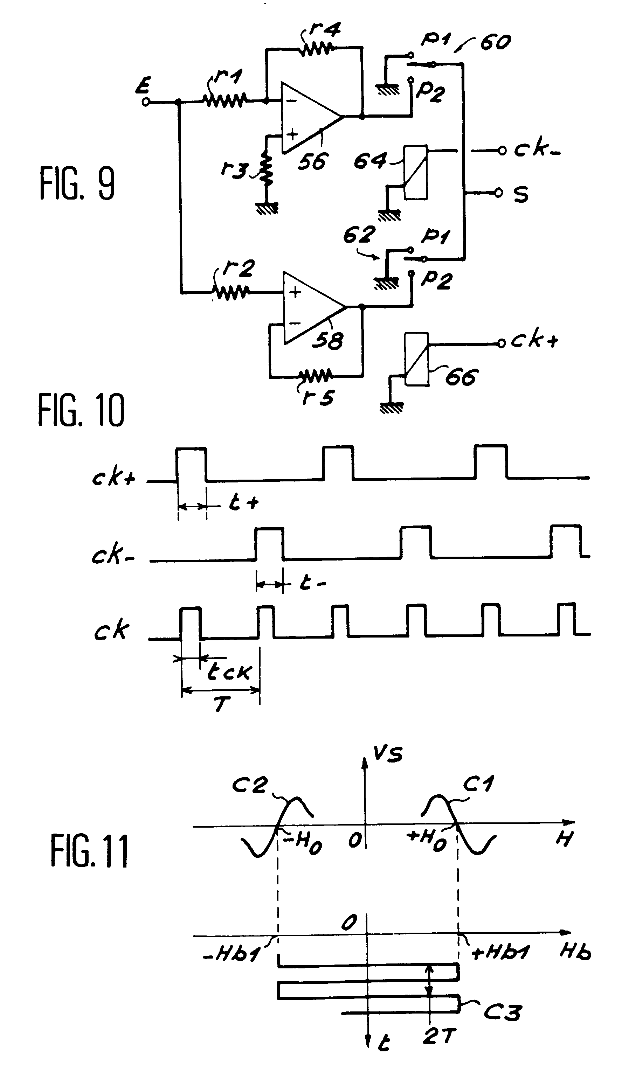

Un générateur de signaux d'horloge 54 permet de commander convenablement les dispositifs 36 et 50 et l'échantillonneur-bloqueur 38 par les signaux ck, ck+ et ck- dont le chronogramme apparaît sur la figure 10.

Ce générateur 54 peut être réalisé au moyen d'un compteur numérique, piloté par une horloge, et de décodeurs d'état, permettant d'obtenir le chronogramme de la figure 10.

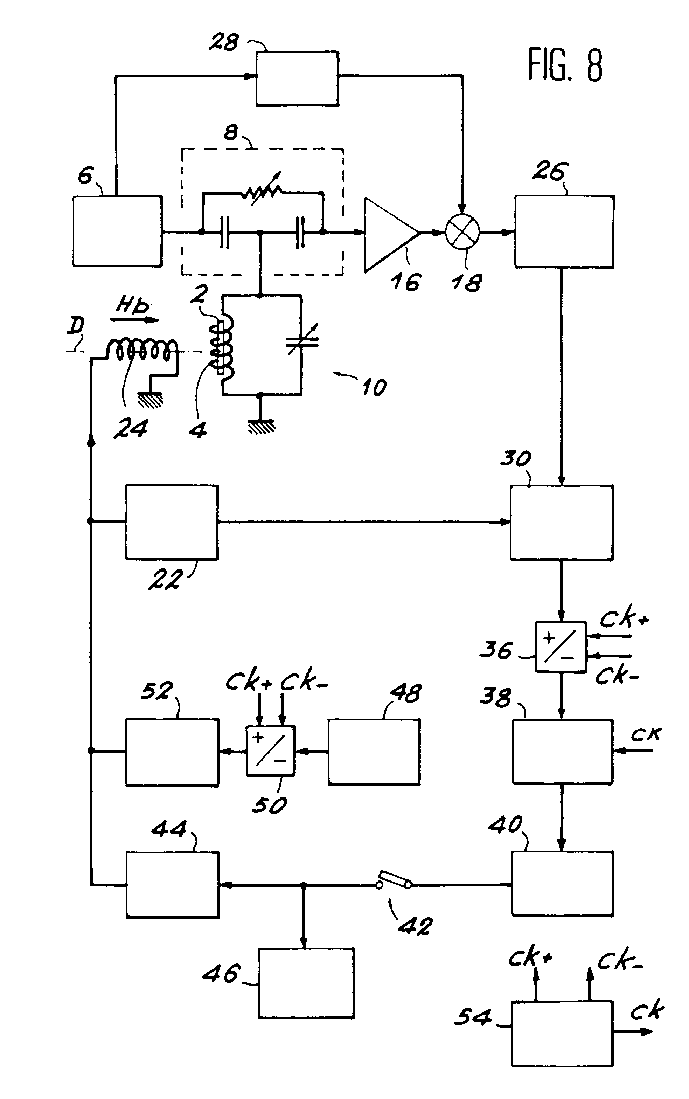

Un autre magnétomètre conforme à l'invention est schématiquement représenté sur la figure 8 et utilise une détection synchrone à fréquence audio.

Le magnétomètre de la figure 8 comprend l'ensemble des éléments référencés 2, 4, 6, 8, 10, 16, 18, 22, 24, 26, 28 et 30 sur la figure 5 et agencés de la même façon que sur cette figure 5.

Le magnétomètre de la figure 8 comprend aussi les éléments référencés 36, 38, 40, 42, 44, 46, 48, 50, 52 et 54 de la figure 7, agencés comme sur cette figure 7, à ceci prés que, dans le cas de la figure 8, la sortie des moyens de détection synchrone 30 est reliée à l'entrée du dispositif 36 et que les convertisseurs 44 et 52 alimentent la bobine 24.

Ainsi, dans le magnétomètre de la figure 8, le champ de polarisation Hb et le champ d'agitation de fréquence audio fm sont engendrés par la même bobine 24 (et sont colinéaires).

Bien entendu, ils pourraient être créés par deux bobines distinctes mais ayant le même axe.

De même, les convertisseurs 44 et 52 de la figure 7 (respectivement 8) pourraient alimenter non pas la même bobine 32 (respectivement 24) mais deux bobines distinctes ayant le même axe.

On notera que, dans le cas de la figure 8, la sortie des moyens de détection synchrone 30 fournit la tension Vs dont les variations en fonction du champ appliqué à l'échantillon 2 sont représentées par la courbe de la figure 6.

Un exemple de réalisation connue du dispositif 36 (ou 50) est schématiquement représenté sur la figure 9 et comprend deux amplificateurs différentiels 56 et 58 et deux relais électromagnétiques 60 et 62 à deux positions p1 (repos) et p2 (travail), dont on voit les bobines respectives 64 et 66 sur la figure 9.

L'entrée E du dispositif de cette figure 9 est reliée à l'entrée inverseuse de l'amplificateur 56 par l'intermédiaire d'une résistance r1 et à l'entrée non inverseuse de l'amplificateur 58 par l'intermédiaire d'une résistance r2.

L'entrée non inverseuse de l'amplificateur 56 est mise à la masse par l'intermédiaire d'une résistance r3.

La sortie de cet amplificateur 56 est reliée à son entrée inverseuse par l'intermédiaire d'une résistance r4.

La sortie de l'amplificateur 58 est reliée à son entrée inverseuse par l'intermédiaire d'une résistance r5.

A titre d'exemple, les résistances r1, r2, r4 et r5 valent 100 kiloohms tandis que la résistance r3 vaut 47 kiloohms.

Entre deux impulsions ck-, le relais 60 est en position p1 et, pendant chaque impulsion ck-, en position p2 dans laquelle la sortie S du dispositif de la figure 9 est reliée à la sortie de l'amplificateur 56.

Entre deux impulsions ck+, le relais 62 est en position p1 et, pendant chaque impulsion ck+, en position p2 dans laquelle la sortie S est reliée à la sortie de l'amplificateur 58.

On décrit maintenant le chronogramme de la figure 10.

Les signaux ck sont des impulsions de largeur temporelle tck et de période T.

Les signaux ck+ sont des impulsions de largeur temporelle t+, supérieure à tck, et de période 2T.

Les signaux ck- sont des impulsions de largeur temporelle t-, supérieure à tck, et de période 2T.

Les impulsions ck sont alternativement recouvertes par des impulsions ck+ et par des impulsions ck-.

On explique ci-après le fonctionnement des magnétomètres des figures 7 et 8.

Supposons l'interrupteur 42 ouvert et le champ Hex faible (Ho très supérieur à Hex).

La valeur de l'intensité I du courant dans la bobine 24 (ou 32) est réglée de telle façon que le champ H correspondant (champ total auquel est soumis l'échantillon) soit approximativement "au centre" de la résonance (H peu différent de Ho).

La variation de la tension V1 (ou VS) à la sortie du filtre 20 (ou des moyens de détection synchrone 30), pour une variation de H positive ou négative, est donnée par la double courbe C1-C2 de la figure 11. Dans ce qui suit, pour faciliter la description, la notation "VS" représentera aussi bien V1 que VS définis plus haut.

C1 est une courbe du genre de celle de la figure 4 ou de la figure 6 et C2 est symétrique de C1 par rapport à l'axe des ordonnées VS.

Pendant une impulsion ck+ du chronogramme de la figure 10, la tension à la sortie du filtre 20 (ou des moyens de détection synchrone 30) vaut :

$$VS+ = -K.(Hb - Ho + H1ex) + Voff$$

K étant une constante de proportionnalité positive correspondant à la partie approximativement linéaire de la courbe de la figure 11 et Voff une tension de décalage, tension résiduelle prenant en compte les défauts de l'appareillage électronique.

L'expression ci-dessus de VS+ est valable si Hex est suffisamment petit pour que l'on reste dans la partie linéaire de la courbe de la figure 11.

Pendant une impulsion ck-, la tension à la sortie du filtre 20 (ou des moyens de détection synchrone 30) vaut :

$$VS- = K.(-(Hb - Ho) + H1ex) + Voff$$

puisque, pendant une impulsion ck-, on se situe du côté des valeurs négatives de H et le dispositif 50 transforme la valeur Vo de la tension fournie par la source 48 en la valeur opposée -Vo.

On voit sur la figure 11 que le champ de polarisation Hb varie alors au cours du temps sous la forme d'impulsions en créneaux (courbe C3), entre deux valeurs Hb1 et -Hb1, Hb1 étant proportionnel à Vo.

La valeur-crête (Hb1) de ce balayage correspond au maximum de la pente de la courbe de la figure 4 (ou 6) à la résonance (H=Ho).

Les erreurs du magnétomètre viennent des variations de la tension Vo fournie par la source 48 et de Voff (qui représente les dérives de l'appareillage électronique).

Nous allons montrer que le magnétomètre de la figure 7 ou 8 compense ces erreurs.

A la sortie du dispositif 36, la tension VS est inversée pendant l'impulsion ck-.

L'échantillonneur-bloqueur 38 mémorise ses valeurs d'entrée pendant les temps morts et les échantillonne pendant les impulsions ck qui apparaissent "à l'intérieur" des impulsions ck+ et ck-, conformément au chronogramme de la figure 10.

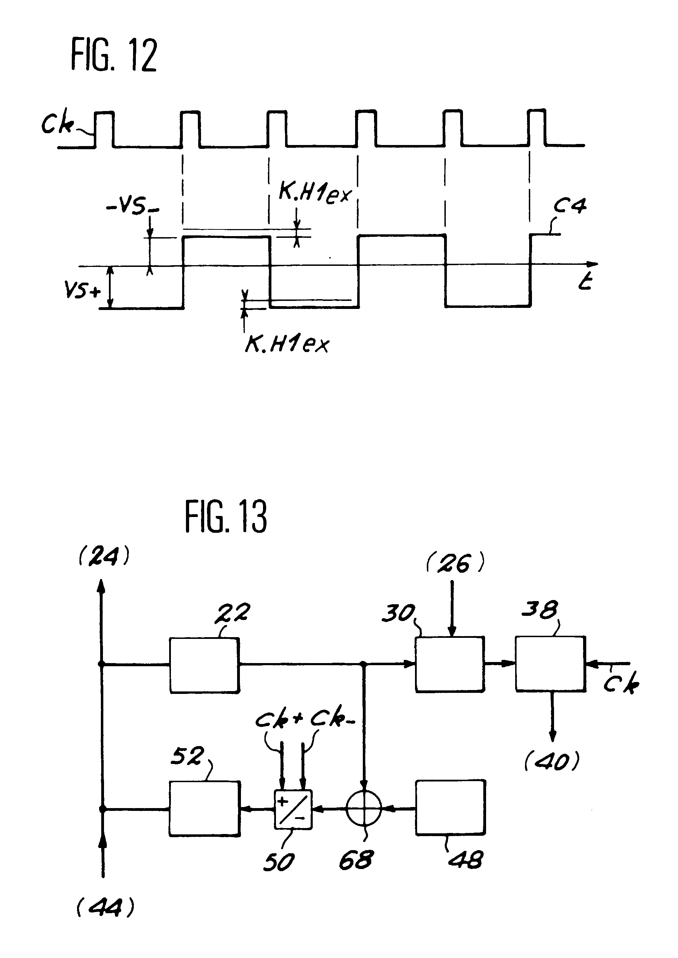

Le signal qui est présent à la sortie de l'échantillonneur-bloqueur 38 est représenté par la courbe C4 de la figure 12.

C'est une succession des valeurs

$-K(Hb - Ho + H1ex)+Voff$ et $-K(-(Hb - Ho) + H1ex)-Voff$

soit VS+ et -VS-, dont la valeur moyenne est :

$$((VS+) + (-VS-))/2 = -K.H1ex.$$

Si Hex varie lentement, il est ainsi possible de suivre ses variations par un simple filtrage passe-bas en sortie de l'échantillonneur-bloqueur 38.

De la sorte, les dérives lentes sont éliminées.

En fait, on est en présence d'un système échantillonné dont la fréquence d'échantillonnage fe est l'inverse du temps T séparant deux impulsions ck.

Conformément à la théorie de tels systèmes, la bande passante maximale du signal d'entrée (H1ex) est égale à fe/2.

Lorsque l'interrupteur 42 est fermé, le signal de sortie de l'échantillonneur-bloqueur 38 intervient en tant que signal d'erreur dans une boucle d'asservissement : sa valeur moyenne est maintenue à zéro par cette boucle et, par l'intermédiaire de l'intégrateur 40 et du convertisseur 44, un courant de contre-réaction est engendré dans la bobine 24 (ou 32) et s'oppose aux variations de Hex.

Dans ce cas, pourvu que le système ait été "accroché" sur la résonance, le "suivi" peut largement excéder la partie linéaire de la courbe de la figure 11 puisque l'on est toujours centré sur la résonance.

Au premier ordre, la linéarité ne dépend plus que du transfert entre le courant et le champ dans la bobine 24 (ou 32).

A la sortie de l'interrupteur 42 (fermé), on obtient un signal de tension qui constitue une image du champ de contre-réaction et qui est proportionnel à H1ex.

Les moyens d'affichage 46 permettent alors de connaître H1ex.

Une variante de réalisation du magnétomètre de la figure 8 est schématiquement et partiellement représentée sur la figure 13.

Dans cette variante, on utilise encore une détection synchrone à la fréquence audio fm mais le dispositif 36 est supprimé.

L'inversion de signe que ce dispositif réalisait est remplacée par une commutation de 180°, à chaque impulsion ck-, de la phase du signal d'excitation de fréquence fm.

Comme on le voit sur la figure 13, on utilise pour ce faire un moyen de sommation 68 qui est monté entre la source de tension 48 et le dispositif 50.

Ce moyen de sommation 68 reçoit en entrée la tension Vo fournie par la source 48 et le signal de fréquence fm issu de l'oscillateur 22 et fournit au dispositif 50 la somme de ces derniers.

Dans les magnétomètres des figures 7 et 8, l'utilisation d'un générateur symétrique de signaux d'horloge 54, tel que t+ et t- soient égaux à T, permet de supprimer l'échantillonneur-bloqueur 38, la sortie du dispositif 36 étant alors directement reliée à l'intégrateur 40.

Bien entendu, en associant trois magnétomètres conformes à l'invention de façon que leurs directions respectives de mesure soient perpendiculaires les unes aux autres, on peut mesurer les trois composantes du champ Hex suivant ces trois directions.

On notera que la présente invention se distingue essentiellement de l'art antérieur par l'utilisation d'un champ de polarisation Hb pulsé en créneaux.

L'utilisation d'un champ Hb pulsé permet de supprimer les dérives lentes en temps et température, surtout celles du courant de polarisation I (envoyé dans la bobine 24 ou 32).

L'utilisation d'un champ en créneaux (de période 2T dans le cas de la figure 10) permet de travailler à l'endroit de pente maximale (par réglage de Vo dans le cas des figures 7, 8 et 13) de la courbe de dispersion ou de la dérivée de la courbe d'absorption et donc d'améliorer le rapport signal/bruit.

L'échantillonneur-bloqueur permet d'éviter des oscillations parasites susceptibles de se produire lors de l'alimentation de la bobine 24 ou 32 par un courant en créneaux.

La diminution de t+ et de t- par rapport à T (figure 9) permet de réduire la puissance dissipée dans la bobine 24 ou 32 et donc la consommation du magnétomètre en énergie.

L'utilisation d'un champ Hb en créneaux associé à un échantillonneur-bloqueur permet par ailleurs de réduire la consommation du magnétomètre.

On notera également un autre avantage de la présente invention - sauf dans le cas de la figure 13-à savoir la compensation des tensions de décalage ("offset") et des dérives, inhérentes à un appareillage électronique.

La présente invention n'est pas limitée à la résonance électronique. Elle peut s'appliquer à la résonance nucléaire : l'échantillon utilisé dans l'invention peut contenir des spins nucléaires, par exemple protoniques, au lieu de spins électroniques.

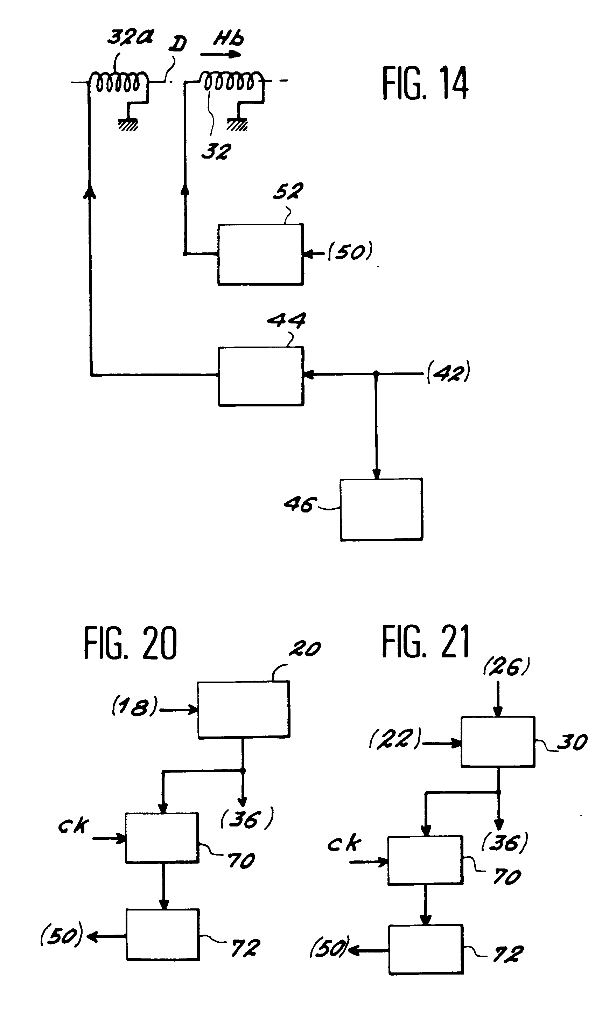

Dans une variante de réalisation du magnétomètre représenté sur la figure 7, la bobine 32 est seulement reliée au convertisseur 52 et permet de créer le champ de polarisation Hb. Une autre bobine 32a (figure 14), ayant le même axe que la bobine 32, est reliée, d'un côté, à la masse et, de l'autre, à la sortie du convertisseur 44 et cette bobine 32a est prévue pour compenser le champ H1ex.

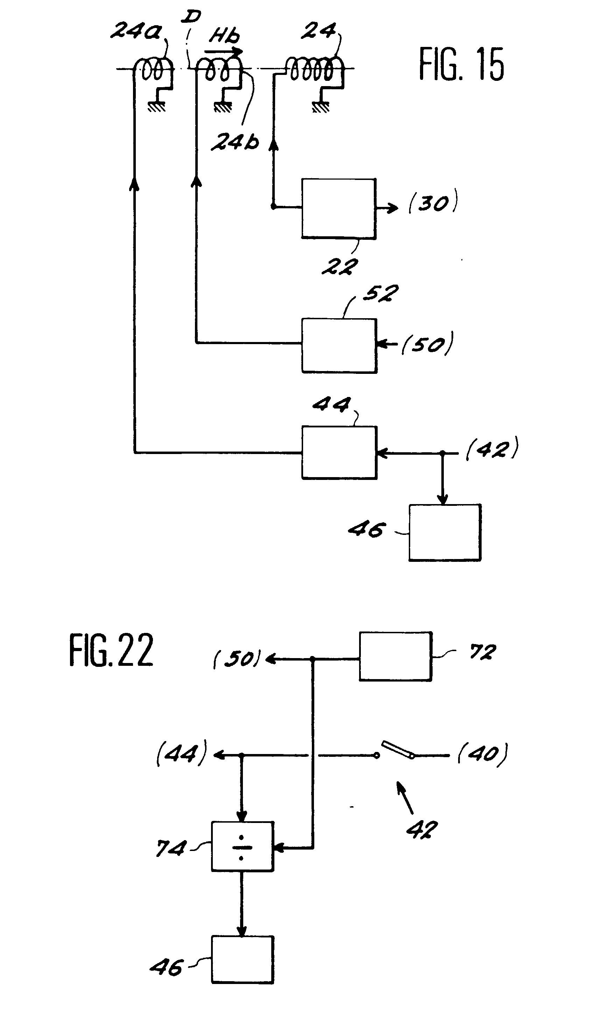

Dans une variante de réalisation du magnétomètre représenté sur la figure 8, la bobine 24 est seulement reliée à l'oscillateur 22 et permet de créer le champ d'agitation à fréquence audio. Une autre bobine 24a (figure 15), ayant le même axe que la bobine 24, est reliée, d'un côté, à la masse et, de l'autre, à la sortie du convertisseur 44 et cette bobine 24a est prévue pour compenser le champ H1ex. Une bobine supplémentaire 24b, ayant le même axe que les bobines 24 et 24a, est reliée, d'une côté, à la masse et, de l'autre, à la sortie du convertisseur 52, et permet de créer le champ de polarisation Hb. Dans une variante non représentée du magnétomètre de la figure 8, on utilise deux bobines ayant le même axe ; l'une de ces deux bobines est reliée à l'un des trois éléments portant les références 22, 44 et 52 en vue de remplir l'une des trois fonctions suivantes : création de Hb, création du champ d'agitation et compensation de H1ex ; l'autre des deux bobines est reliée aux deux autres des trois éléments en vue de remplir les deux autres fonction. Par exemple, l'une des deux bobines est reliée à l'oscillateur 22 pour engendrer le champ d'agitation et l'autre bobine est reliée aux convertisseurs 44 et 52 en vue de créer le champ de polarisation Hb et de compenser le champ H1ex.

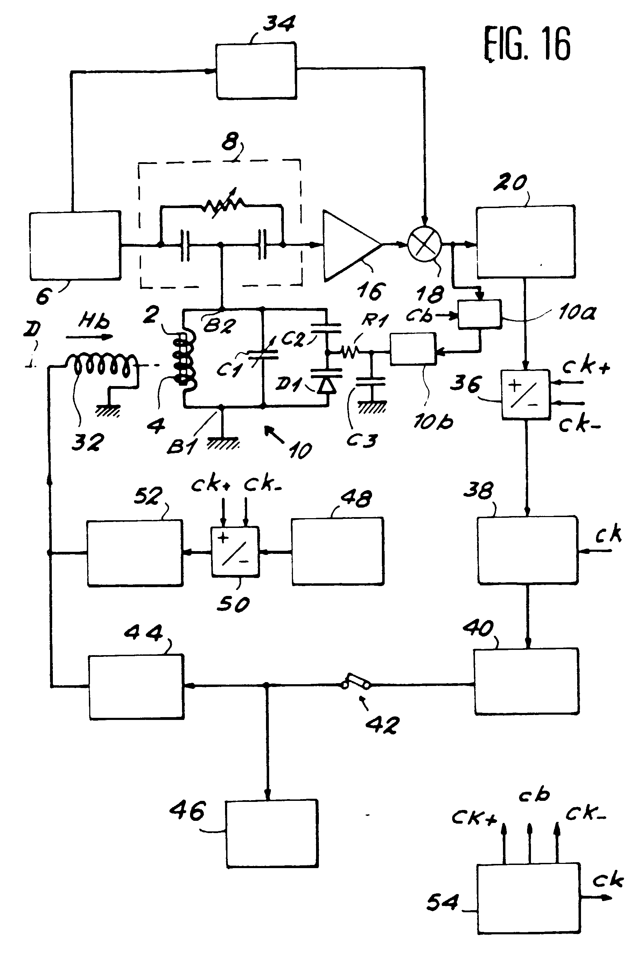

Le circuit résonant 10 (voir figures 7 et 8), qui est accordé à la fréquence fo, peut se dérégler. Pour maintenir ce circuit résonant 10 accordé à la fréquence fo, on peut modifier le magnétomètre représenté sur la figure 7 comme on l'explique ci-après en faisant référence à la figure 16.

On ajoute au circuit résonant 10 un condensateur c2, une diode à capacité variable D1, une résistance de polarisation R1 et un condensateur c3. De plus, on ajoute au magnétomètre de la figure 7 un échantillonneur-bloqueur 10a et un intégrateur 10b.

A titre purement indicatif et nullement limitatif, la diode D1 est du genre de celle qui est commercialisée par RTC sous la référence OF 143, la résistance R1 vaut 100 kilo-ohms et les condensateurs c2 et c3 ont tous deux une capacité de 10 nF.

La borne B1 du circuit résonant 10, qui est commune à la bobine 4 et au condensateur variable c1 et qui est mise à la masse, est reliée à l'anode de la diode D1. La cathode de cette diode D1 est reliée à une borne du condensateur c2 (qui a pour fonction d'éviter la mise en court-circuit de la diode D1 par la bobine 4) et à une borne de la résistance R1. L'autre borne du condensateur c2 est reliée à l'autre borne B2 du condensateur variable c1. L'échantillonneur-bloqueur 10a est commandé par des signaux d'horloge impulsionnels cb et son entrée est reliée à la sortie du mélangeur équilibré 18 tandis que sa sortie est reliée à l'entrée de l'intégrateur 10b. La sortie de ce dernier est reliée à l'autre borne de la résistance R1 ainsi qu'à une borne du condensateur c3 dont l'autre borne est mise à la masse et qui a pour fonction d'éviter des fuites de signaux de haute fréquence vers l'intégrateur 10b, ces signaux provenant du générateur 6.

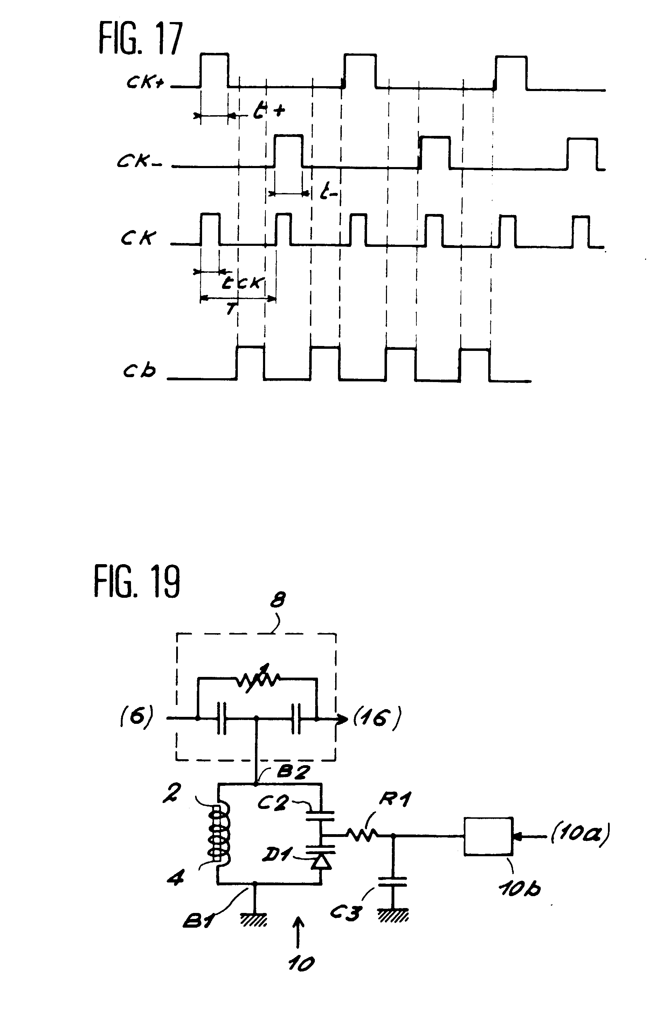

Les signaux cb, qui servent à commander l'échantillonneur-bloqueur 10a, sont définis par des tensions positives. Ces signaux cb, dont le chronogramme apparaît sur la figure 17, sont des signaux logiques en créneaux dont les impulsions non nulles apparaissent en dehors de celles des signaux ck+ et ck-. Comme ces derniers, les signaux cb sont fournis par le générateur 54 qui est convenablement modifié de façon à obtenir le chronogramme de la figure 17.

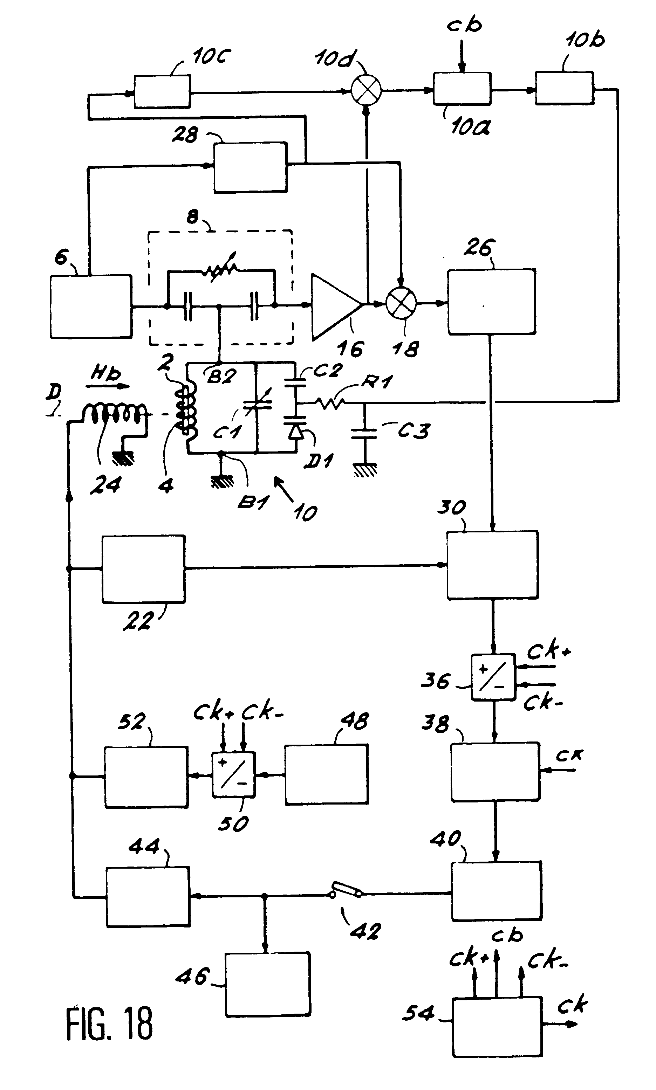

Le magnétomètre de la figure 8 peut être modifié comme on l'explique ci-après, en faisant référence à la figure 18 pour maintenir son circuit résonant 10 accordé à la fréquence fo.

On ajoute au magnétomètre de la figure 8 les éléments qui portent les références c2, c3, D1, R1, 10a et 10b agencés de la même façon que dans la figure 16 excepté que l'entrée de l'échantillonneur-bloqueur 10a n'est pas, dans le cas de la figure 18, relié à la sortie du mélangeur 18 : pour obtenir le magnétomètre de la figure 18, on ajoute en outre au magnétomètre de la figure 8 un déphaseur 10c et un autre mélangeur équilibré 10 d (du même type que le mélangeur 18) ; le déphaseur 10c reçoit le signal de haute fréquence issu du déphaseur 28 et fournit au mélangeur 10d un signal de référence qui est déphasé de +90° ou de -90° par rapport au signal de référence du mélangeur 18, le signe de ce déphasage étant choisi tel que l'asservissement de l'accord du circuit résonant soit stable ; le signal de sortie de l'amplificateur 16 est aussi envoyé à l'entrée du mélangeur 10d dont la sortie est reliée à l'entrée de l'échantillonneur-bloqueur 10a.

Dans une variante de réalisation, le condensateur variable c1 des figures 16 et 18 est supprimé comme on le voit sur la figure 19 : alors l'ensemble D1-c2 est simplement monté entre les bornes B1 et B2.

Les magnétomètres conformes à l'invention peuvent être avantageusement munis de moyens aptes à maintenir automatiquement la polarisation de l'échantillon 2 à une valeur Hb1 égale à Ho (ou plus exactement à maintenir respectivement égales à Ho et à -Ho les valeurs maximale Hb1 et minimale -Hb1 de Hb et ce, de manière automatique), en asservissant la source de tension 48 à un signal d'erreur Veps obtenu en faisant l'opération :

$$Veps=(VS+)+(VS-)=-2K.(Hb-Ho)+2Voff.$$

Si l'on sait faire en sorte que Voff soit petit, ou, plus exactement, soit négligeable devant K.(Hb-Ho), ce qui est possible en utilisant des circuits électroniques à faible dérive, le terme Veps permet d'asservir la tension Vo de telle façon que Hb1 soit strictement égale à Ho. En l'absence d'un tel asservissement, une légère variation de Hb1 autour de Ho n'introduit pas de dérive du magnétomètre mais conduit à une dégradation du rapport signal sur bruit dès que l'on sort de la zone de pente maximale de la courbe de la figure 4 ou de la courbe de la figure 6 (voir aussi le document (5)). De plus, le réglage de la source 48 à la valeur Vo peut être délicat si la raie de résonance est fine, c'est-à-dire si DH1 et DH2 sont faibles devant Ho. le maintien automatique de la polarisation de l'échantillon à la valeur Ho est donc avantageux en ce qu'il permet d'exploiter le magnétomètre avec un rapport signal sur bruit optimal et d'éviter le réglage de la source de tension 48.

Ce maintien automatique est obtenu (voir figures 20 et 21) en remplaçant la source 48 par l'assocation d'un échantillonneur-bloqueur 70 identique à celui qui porte la référence 38 et d'un intégrateur 72 identique à celui qui porte la référence 40.

Plus précisément, pour un magnétomètre du genre de celui de la figure 7, le signal de sortie du filtre 20 (figure 20) est envoyé non seulement au dispositif 36 mais aussi à l'entrée de l'échantillonneur-bloqueur 70 qui est commandé par les signaux ck et dont la sortie est reliée à l'entrée de l'intégrateur 72. La sortie de ce dernier est reliée à l'entrée du dispositif 50.

Pour un magnétomètre du genre de celui de la figure 8, c'est le signal de sortie des moyens de détection synchrone 30 (figure 21) qui est envoyé non seulement au dispositif 36 mais aussi à l'entrée de l'échantillonneur-bloqueur 70. Ce dernier est encore relié à l'intégrateur 72 lui-même relié au dispositif 50 comme on l'a vu précédemment à propos de la figure 20.

A la sortie de l'intégrateur 72, on a donc une tension Vo proportionnelle à H0 (valeur du champ magnétique reliée à la fréquence fo de résonance des spins par la relation de Larmor).

Les magnétomètres conformes à l'invention peuvent aussi être avantageusement munis de moyens aptes à éliminer les dérives de ces magnétomètres, dues aux variations de coefficient de transfert liées aux variations dimensionnelles des deuxièmes moyens magnétiques qui, dans les exemples représentés, comprennent les bobines 24, 24a, 24b, 32 et 32a. En effet, un autre inconvénient de ces magnétomètres, et d'ailleurs de tous les magnétomètres à contre-réaction de champ, réside dans les variations dimensionnelles de leur bobine de contre-réaction (référence 32 sur la figure 7 et référence 24 sur la figure 8). Ces variations sont notamment dues à la température.

En effet, le signal de sortie Vmes du magnétomètre, lu à la sortie de l'interrupteur 42 (lorsque ce dernier est fermé), peut s'exprimer par la relation :

$$Vmes = -A.H1ex.$$

On note TB le rapport entre le courant dans la bobine de contre-réaction et le champ de contre-réaction -H1ex et l'on note R le rapport entre Vmes et le courant de contre-réaction dû au convertisseur 44. On peut écrire :

$$A = R.TB \text{ et } Vmes = -R.TB-H1ex$$

Quand H1ex est "en extrémité d'échelle", l'incidence des variations de TB sur Vmes peut être importante. A titre d'exemple, une valeur de 100 microteslas pour H1ex et une résolution souhaitée de 100 picoteslas correspondent à une variation de $10^{-6}$ tolérable sur le produit R.TB. Une telle précision peut être maintenue sur l'élément 44 mais pas sur les variations dimensionnelles de la bobine de contre-réaction (bobine 32 sur la figure 7) surtout si cette dernière est soumise à des variations de température. Pour un magnétomètre destiné à être utilisé dans une large gamme de températures, de -30°C à +70°C par exemple, et avec un support de bobine réalisé en un matériau très performant, dont le coefficient de dilatation vaut par exemple $10^{-5}$/°C, on obtient une variation relative de $10^{-3}$ sur toute la gamme de température, ce qui provoque une erreur de 100 nT si le champ à mesurer est en extrémité d'échelle. En général, ce phénomène est soit non compensé soit compensé en mesurant la température et en appliquant des coefficients de correction soit éliminé en maintenant la température des deuxièmes moyens magnétiques constante. La compensation par des coefficients de correction est limitée, le phénomène de dilatation étant souvent irréversible. En outre, le maintien à température constante nécessite des moyens supplémentaires.

Dans la présente invention, on résout ce problème de variations dimensionnelles de la manière suivante, à condition que la bobine de contre-réaction et la bobine créant le champ de polarisation aient le même coefficient TB ou qu'elles soient confondues (cas des figures 7 et 8).

Soient R44 et R52 les rapports tension/courant respectifs des convertisseurs 44 et 52 (qui sont par exemple des résistances électriques). On peut écrire :

$$Vo=R52.TB.Ho = R52.TB.2pi.fo/(g.Mo)$$

en raison de la relation de Larmor. De plus, on peut écrire :

$$Vmes = -R44.TB.H1ex.$$

Le problème des variations dimensionnelles est résolu en ajoutant au magnétomètre de la figure 20 (ou à celui de la figure 21) un élément 74 (figure 22), entre la sortie de l'interrupteur 42 et l'entrée des moyens d'affichage 46. Cet élément 74 reçoit en entrée le signal de sortie de l'interrupteur 42 (Vmes) et le signal de sortie de l'intégrateur 72 et est apte à faire l'opération Vmes/Vo dont le résultat est ainsi envoyé à l'entrée des moyens 46. Cet élément 74 est soit un diviseur analogique (du genre de ceux qui sont commercialisés par Analog Device) soit un moyen analogique-numérique connu tel qu'un voltmètre-calculateur à deux entrées incluant alors la fonction de l'élément 46 qui est supprimée.

On peut écrire :

$$Vmes/Vo = -(R44/R52).g.Mo.H1ex/(2pi.fo).$$

Les variations de TB sont donc éliminées. Les facteurs restant contribuant à la précision sont :

- fo dont la précision est donnée par le générateur 6 et peut aisément atteindre $10^{-8}$ ou mieux (si l'on utilise par exemple un oscillateur stabilisé par quartz ou un oscillateur thermalisé),
- le rapport R44/R52 qui est constant si les deux convertisseurs 44 et 52 dérivent de la même manière (par exemple s'ils sont soumis à la même température et ont la même dérive thermique).

DOCUMENTS CITES

(1) F.M. Neibauer et al., The Giotto magnetometer experiment, J. Phys. E:Sci. Instrum.20 (1987), p. 714 à 720.

(2) US-A-191118, P.Jung et al.

(3) D. Bourdel et al., Un magnétomètre à résonance électronique, optimisation des performances, Revue de Physique Appliquée, Tome 5, février 1970, p.187 à 190.

(4) D. Bourdel et al., Amélioration de la sensibilité des magnétomètres à résonance paramagnétique, Revue de Physique Appliquée, Tome 7, mars 1972, p.23 à 27

(5) Demande de brevet français n° 8809830 du 20 juillet 1988 et EP-A-0359598, D. Duret et M. Beranger.

(6) Demande de brevet français n° 8612278 du 1 septembre 1986, M. Dufour et C. Salvi.

(7) Demande de brevet français n° 8717566 du 16 décembre 1987, J. Crescini et D. Duret.

**Revendications**

1. Magnétométre directionnel à résonance, destiné à mesurer un champ magnétique H1ex qui est la projection, sur une direction déterminée (D), d'un champ magnétique Hex, ce magnétométre comprenant :

   - un échantillon (2) fait d'un matériau comportant des spins résonants,
   - des premiers moyens magnétiques (4) placés au voisinage de.l'échantillon et prévus pour exciter la résonance des spins et pour détecter la résonance excitée, et
   - des deuxièmes moyens magnétiques (24, 32, 32a, 24a, 24b) placés au voisinage de l'échantillon et prévus pour engendrer un champ magnétique de polarisation Hb suivant la direction déterminée et pour compenser le champ H1ex,

   magnétométre caractérisé en ce qu'il comprend en outre :

   - des moyens de traitement et d'asservissement (6, 8, 16, 18, 20 ou 22-26-28-30, 36-38-48-50-52 ou 38-48-50-52-68; 40, 44) qui sont reliés aux premiers moyens magnétiques (4) et aux deuxièmes moyens magnétiques (24, 32) et servent à obtenir des valeurs de tensions respectivement proportionnelles à (Hb - Ho + H1ex) et à (Ho - Hb + H1ex) au voisinage de la résonance, Ho étant la valeur du champ magnétique appliqué à l'échantillon à la résonance et étant très supérieur à Hex, et un courant pulsé en créneaux permettant d'induire le champ Hb par l'intermédiaire des deuxièmes moyens magnétiques (24, 32, 32a, 24a, 24b), et de fournir une tension (Vmes) proportionnelle à ce champ H1ex.

2. Magnétométre selon la revendication 1, caractérisé en ce que les moyens de traitement et d'asservissement comprennent :

   - des moyens de traitement (6, 8, 16, 18, 20 ou 22-26-28-30, 36-38-48-50-52 ou 38-48-50-52-68) reliés aux premiers moyens magnétiques (4) et aux deuxièmes moyens magnétiques (24, 32) et permettant d'obtenir d'une part des valeurs de tensions respectivement proportionnelles à (Hb - Ho + H1ex) et à (Ho - Hb + H1ex) au voisinage de la résonance, Ho étant la valeur du champ magnétique appliqué à l'échantillon à la résonance et étant très supérieur à Hex, et d'autre part un courant pulsé en créneaux permettant d'induire le champ Hb par l'intermédiaire des deuxièmes moyens magnétiques (24, 32, 32a, 24a, 24b), et
   - des moyens d'asservissement (40, 44) qui sont reliés d'une part aux moyens de traitement et d'autre part aux deuxièmes moyens magnétiques (24, 32, 32a, 24a, 24b) pour compenser le champ H1ex, et qui fournissent une tension proportionnelle à ce champ H1ex.

3. Magnétomètre selon la revendication 2, caractérisé en ce que les moyens d'asservissement comprennent un intégrateur (40), qui est commandé par les moyens d'asservissement, et un convertisseur tension-courant (44) dont l'entrée est reliée à la sortie de l'intégrateur et dont la sortie alimente les deuxièmes moyens magnétiques (24, 32, 32a, 24a, 24b).

4. Magnétomètre selon l'une quelconque des revendications 2 et 3, caractérisé en ce que les moyens de traitement comprennent :

- des moyens électroniques (6, 8, 16, 18, 20) prévus pour alimenter les premiers moyens magnétiques (4) par un courant à la fréquence de Larmor correspondant à Ho et pour fournir en sortie un signal de tension dont les variations en fonction du champ magnétique appliqué à l'échantillon (2) correspondent à la courbe de dispersion de cet échantillon,
- un premier dispositif électronique (36) relié à la sortie des moyens électroniques et permettant un gain en tension valant alternativement +1 et -1,
- un échantillonneur-bloqueur (38) dont l'entrée est reliée à la sortie du premier dispositif électronique (36) et dont la sortie commande les moyens d'asservissement (40, 44),
- une source de tension électrique (48, 70, 72),
- un deuxième dispositif électronique (50) alimenté par cette source (48, 70, 72) et permettant un gain en tension valant alternativement +1 et -1, et
- un autre convertisseur tension-courant (52) dont l'entrée est reliée à la sortie du deuxième dispositif électronique (50) et qui alimente les deuxièmes moyens magnétiques (24, 32, 32a, 24a, 24b).

5. Magnétomètre selon l'une quelconque des revendications 2 et 3, caractérisé en ce que les moyens de traitement comprennent :

- des moyens électroniques (6, 8, 16, 18, 22, 26, 28, 30) prévus pour alimenter les premiers moyens magnétiques (4) par un courant à la fréquence de Larmor correspondant à Ho et pour fournir en sortie, grâce à une détection synchrone commandée par un signal de tension à une fréquence audio, un signal de tension dont les variations en fonction du champ magnétique appliqué à l'échantillon (2) correspondent à la dérivée de la courbe d'absorption de cet échantillon,
- un premier dispositif électronique (36) relié à la sortie des moyens électroniques et permettant un gain en tension valant alternativement +1 et -1,
- un échantillonneur-bloqueur (38) dont l'entrée est reliée à la sortie du premier dispositif électronique (36) et dont la sortie commande les moyens d'asservissement (40, 44),
- une source de tension électrique (48, 70, 72),
- un deuxième dispositif électronique (50) alimenté par cette source (48, 70, 72) et permettant un gain en tension valant alternativement +1 et -1, et
- un autre convertisseur tension-courant (52) dont l'entrée est reliée à la sortie du deuxième dispositif électronique (50) et qui alimente les deuxièmes moyens magnétiques (24, 32, 32a, 24a, 24b).

6. Magnétomètre selon l'une quelconque des revendications 2 et 3, caractérisé en ce que les moyens de traitement comprennent :

- des moyens électroniques (6, 8, 16, 18, 22, 26, 28, 30) prévus pour alimenter les premiers moyens magnétiques (4) par un courant à la fréquence de Larmor correspondant à Ho et pour fournir en sortie, grâce à une détection synchrone commandée par un signal de tension à une fréquence audio, un signal de tension dont les variations en fonction du champ magnétique appliqué à l'échantillon (2) correspondent à la dérivée de la courbe d'absorption de cet échantillon,
- un échantillonneur-bloqueur (38) dont l'entrée est reliée à la sortie des moyens électroniques et dont la sortie commande les moyens d'asservissement (40, 44),
- une source de tension électrique (48, 70, 72),
- un moyen de sommation (68) prévu pour fournir en sortie un signal de tension égal à la somme de cette tension et du signal à fréquence audio,
- un dispositif électronique (50) relié à la sortie du moyen de sommation (68) et permettant un gain en tension valant alternativement +1 et -1, et
- un autre convertisseur tension-courant (52) dont l'entrée est reliée à la sortie du dispositif électronique (50) et qui alimente les deuxièmes moyens magnétiques (24, 32, 32a, 24a, 24b).

7. Magnétomètre selon l'une quelconque des revendications 1 à 6, caractérisé en ce que les deuxièmes moyens magnétiques comprennent une première bobine magnétique (32, 24b) pour engendrer le champ de polarisation Hb et une deuxième bobine magnétique (32a, 24a) pour compenser le champ H1ex, la première et la deuxième bobine ayant le même axe.

8. Magnétomètre selon l'une quelconque des revendications 5 et 6, caractérisé en ce que les deuxièmes moyens magnétiques comprennent une première bobine magnétique (24) pour créer, dans l'échantillon, un champ magnétique d'agitation à la fréquence audio, une deuxième bobine magnétique (24b) pour engendrer le champ de polarisation Hb et une troisième bobine magnétique (24a) pour compenser le champ H1ex, les première, deuxième et troisième bobines ayant le même axe.

9. Magnétomètre selon l'une quelconque des revendications 5 et 6, caractérisé en ce que les deuxièmes moyens magnétiques comprennent une première bobine magnétique pour remplir l'une des trois fonctions de création du champ de polarisation, de compensation du champ H1ex et de création, dans l'échantillon, d'un champ magnétique d'agitation à la fréquence audio, et une deuxième bobine magnétique pour remplir les deux autres de ces trois fonctions, les première et deuxième bobines ayant le même axe.

10. Magnétomètre selon l'une quelconque des revendications 1 à 9, caractérisé en ce qu'il comprend un circuit résonant (10) qui incorpore les premiers moyens magnétiques (4) et qui est accordé à la fréquence fo de la résonance ainsi que des moyens (c2, c3, D1, R1, 10a, 10b; c2, c3, D1, R1, 10a, 10b, 10c, 10d) aptes à maintenir le circuit résonant (10) accordé à la fréquence fo.

11. Magnétomètre selon l'une quelconque des revendications 1 à 10, caractérisé en ce qu'il comprend en outre des moyens (70, 72) aptes à maintenir respectivement égales à Ho et à -Ho les valeurs maximale et minimale du champ de polarisation.

12. Magnétomètre selon l'une quelconque des revendications 1 à 11, caractérisé en ce que les deuxièmes moyens magnétiques comprennent une bobine magnétique (24, 32) apte à engendrer le champ magnétique de polarisation Hb, en ce que les moyens de traitement et d'asservissement comprennent des moyens (70, 72, 50, 52) d'alimentation électrique de cette bobine, ces moyens d'alimentation comprenant une source de tension (70, 72), et en ce que les moyens de traitement et d'asservissement comprennent en outre un moyen (74) apte à fournir en sortie un signal égal à ladite tension (Vmes) proportionnelle au champ H1ex, divisée par la tension de la source (70, 72).

**Patentansprüche**

1. Resonanz- und Richtungsmagnetometer zur Messung eines Magnetfelds Hlex, das , in einer festgelegten Richtung (D), die Projektion eines Magnetfelds Hex ist, wobei dieses Magnetron umfaßt:

    - eine Probe (2) aus einem Material, das Resonanz-Spins aufweist,
    - erste magnetische Einrichtungen (4), angeordnet in der Nähe des Musters und vorgesehen zum Anregen bzw. Erregen der Spins und zum Detektieren der angeregten Resonanz, und
    - zweite magnetische Einrichtungen (24, 32, 32a, 24a, 24b), angeordnet in der Nähe des Musters und vorgesehen, um ein Polarisationsmagnetfelds Hb in der festgelegten Richtung zu erzeugen und um das Feld Hlex zu kompensieren,

wobei dieses Magnetometer **dadurch gekennzeichnet ist**, daß es außerdem umfaßt:

    - Verarbeitungseinrichtungen (6, 8, 16, 18, 20 oder 22-26-28-30, 36-38-48-50-52 oder 38-48-50-52-68; 40, 44), die mit den ersten magnetischen Einrichtungen (4) und mit den zweiten magnetischen Einrichtungen (24, 32) verbunden sind und dazu dienen, Spannungswerte jeweils proportional zu (Hb - Ho + Hlex) und zu (Ho - Hb + Hlex) nahe der Resonanz zu erhalten, wobei Ho der Wert des auf das Muster bei Resonanz angewandten Magnetfeldes ist und sehr viel größer als Hex ist, und einen mit Rechteckimpulsen pulsierenden Strom, der ermöglicht, das Feld Hb durch die zweiten magnetischen Einrichtungen (24, 32, 32a, 24a, 24b) zu induzieren und eine Spannung (Vmes) proportional zu diesem Feld Hlex zu liefern.

2. Magnetometer nach Anspruch 1, dadurch gekennzeichnet, daß die Verarbeitungs- und Regeleinrichtungen umfassen:

    - Verarbeitungs- und Regeleinrichtungen (6, 8, 16, 18, 20 oder 22-26-28-30, 36-38-48-50-52 oder 38-48-50-52-68), die mit den ersten magnetischen Einrichtungen (4) und mit den zweiten magnetischen Einrichtungen (24, 32) verbunden sind und ermöglichen, einerseits Spannungswerte zu erhalten, die proportional sind zu (Hb - Ho + H1ex) und zu (Ho - Hb + H1ex) nahe der Resonanz, wobei Ho der Wert des auf das Muster bei Resonanz angewandten Magnetfeldes ist und sehr viel größer als Hex ist, und andererseits einen mit Rechteckimpulsen pulsierender Strom, der ermöglicht, das Feld Hb durch die zweiten magnetischen Einrichtungen (24, 32, 32a, 24a, 24b) zu induzieren, und
    - Regeleinrichtungen (40, 44), die einerseits mit den Verarbeitungseinrichtungen verbunden sind und andererseits mit den zweiten magnetischen Einrichtungen (24, 32, 32a, 24A, 24b) um das Feld Hlex zu kompensieren, und die eine zu diesem Feld Hlex proportionale Spannung liefern.

3. Magnetometer nach Anspruch 2, dadurch gekennzeichnet, daß die Regeleinrichtungen einen Integrator (40) umfassen, der durch die Regeleinrichtungen gesteuert wird, und einen Spannungs-Strom-Wandler bzw. -Umsetzer (44), dessen Eingang mit dem Ausgang des Integrators verbunden ist und dessen Ausgang die zweiten magnetischen Einrichtungen (24, 32, 32a, 24a, 24b) versorgt.

4.  Magnetometer nach einem der Ansprüche 2 und 3, dadurch gekennzeichnet, daß die Verarbeitungseinrichtungen umfassen:

    -   elektronische Einrichtungen (6, 8, 16, 18, 20) um die ersten magnetischen Einrichtungen (4) mit einem Strom mit der Ho entsprechenden Larmorfrequenz zu versorgen und als Ausgang ein Spannungssignal zu liefern, dessen Veränderungen in Abhängigkeit von dem auf das Muster (2) angewandten Magnetfeld der Dispersionskurve dieses Musters entsprechen,
    -   eine erste elektronische Vorrichtung (36), verbunden mit dem Ausgang der elektronischen Einrichtungen, die eine Spannungsverstärkung ermöglicht, die abwechseln +1 und -1 beträgt,
    -   eine Abtast- und Halteschaltung (38), deren Eingang mit dem Ausgang der ersten elektronischen Vorrichtung (36) verbunden ist und deren Ausgang die Regeleinrichtungen (40, 44) steuert,
    -   eine elektrische Spannungsquelle (48, 70, 72),
    -   eine zweite elektronische Vorrichtung (50), versorgt durch diese Quelle (48, 70, 72), die eine Spannungsverstärkung ermöglicht, die abwechseln +1 und -1 beträgt, und
    -   einen anderen Spannungs-Strom-Wandler (52), dessen Eingang mit dem Ausgang der zweiten elektronischen Vorrichtung (50) verbunden ist und der die zweiten magnetischen Einrichtungen (24, 32, 32a, 24a, 24b) versorgt

5.  Magnetometer nach einem der Ansprüche 2 und 3, dadurch gekennzeichnet, daß die Verarbeitungseinrichtungen umfassen:

    -   elektronische Einrichtungen (6, 8, 16, 18, 22, 26, 28, 30) um die ersten magnetischen Einrichtungen (4) mit einem Strom mit der Ho entsprechenden Larmorfrequenz zu versorgen und, dank einer synchronen Detektion, gesteuert durch ein Spannungssignal mit einer Audiofrequenz, als Ausgang ein Spannungssignal zu liefern, dessen Veränderungen in Abhängigkeit von dem auf das Muster (2) angewandten Magnetfeld der Ableitung der Absorptionskurve dieses Musters entsprechen,
    -   eine erste elektronische Vorrichtung (36), verbunden mit dem Ausgang der elektronischen Einrichtungen, die eine Spannungsverstärkung ermöglicht, die abwechseln +1 und -1 beträgt,
    -   eine Abtast- und Halteschaltung (38), deren Eingang mit dem Ausgang der ersten elektronischen Vorrichtung (36) verbunden ist und deren Ausgang die Regeleinrichtungen (40, 44) steuert,

    -   eine elektrische Spannungsquelle (48, 70, 72),
    -   eine zweite elektronische Vorrichtung (50), versorgt durch diese Quelle (48, 70, 72), die eine Spannungsverstärkung ermöglicht, die abwechseln +1 und -1 beträgt, und
    -   einen anderen Spannungs-Strom-Wandler (52), dessen Eingang mit dem Ausgang der zweiten elektronischen Vorrichtung (50) verbunden ist und der die zweiten magnetischen Einrichtungen (24, 32, 32a, 24a, 24b) versorgt.

6.  Magnetometer nach einem der Ansprüche 2 und 3, dadurch gekennzeichnet, daß die Verarbeitungseinrichtungen umfassen:

    -   elektronische Einrichtungen (6, 8, 16, 18, 22, 26, 28, 30) um die ersten magnetischen Einrichtungen (4) mit einem Strom mit der Ho entsprechenden Larmorfrequenz zu versorgen und, dank einer synchronen Detektion, gesteuert durch ein Spannungssignal mit einer Audiofrequenz, als Ausgang ein Spannungssignal zu liefern, dessen Veränderungen in Abhängigkeit von dem auf das Muster (2) angewandten Magnetfeld der Ableitung der Absorptionskurve dieses Musters entsprechen,
    -   eine Abtast- und Halteschaltung (38), deren Eingang mit dem Ausgang der elektronischen Einrichtungen verbunden ist und deren Ausgang die Regeleinrichtungen (40, 44) steuert,
    -   eine elektrische Spannungsquelle (48, 70, 72),
    -   eine Summierungseinrichtung (68), vorgesehen um als Ausgang ein Spannungssignal gleich der Summe dieser Spannung und des Audiofrequenzsignals zu liefern,
    -   eine elektronische Vorrichtung (50), verbunden mit dem Ausgang der Summierungseinrichtung (68), die eine Spannungsverstärkung ermöglicht, die abwechseln +1 und -1 beträgt, und
    -   einen anderen Spannungs-Strom-Wandler (52), dessen Eingang mit dem Ausgang der elektronischen Vorrichtung (50) verbunden ist und der die zweiten magnetischen Einrichtungen (24, 32, 32a, 24a, 24b) versorgt.

7.  Magnetometer nach einem der Ansprüche 1 bis 6, dadurch gekennzeichnet, daß die zweiten magnetischen Einrichtungen eine erste Magnetspule (32, 24b) umfassen, um das Polarisationsfeld Hb zu erzeugen, und eine zweite Magnetspule (32a, 24a), um das Magnetfeld Hlex zu kompensieren, wobei die erste und die zweite Spule dieselbe Achse haben.

8.  Magnetometer nach einem der Ansprüche 5 und 6, dadurch gekennzeichnet, daß die zweiten magnetischen Einrichtungen eine erste Magnetspule (24) umfassen, um in dem Muster ein magnetisches Erregungsfeld mit der Audiofrequenz zu erzeugen, und eine zweite Magnetspule (24b), um das Polarisationsfeld Hb zu erzeugen, sowie eine dritte Magnetspule (24a), um das Feld Hlex zu erzeugen, wobei die erste, zweite und dritte Spule dieselbe Achse haben.

9. Magnetometer nach einem der Ansprüche 5 und 6, dadurch gekennzeichnet, daß die zweiten mangnetischen Einrichtungen eine erste Magnetspule umfassen, um eine der drei Funktionen des Erzeugens des Polarisationsfeldes, der Kompensation des Feldes Hlex und der Erzeugung eines magnetischen Erregungsfeldes mit der Audiofrequenz in dem Muster zu erfüllen, und eine zweite magnetische Spule, um die beiden anderen dieser drei Funktionen zu erfüllen, wobei die erste und die zweite Spule dieselbe Achse haben.

10. Magnetometer nach einem der Ansprüche 1 bis 9, dadurch gekennzeichnet, daß es einen Resonanz- bzw. Schwingkreis (10) umfaßt, der die beiden magnetischen Einrichtungen (4) enthält und der abgestimmt ist auf die Frequenz fo der Resonanz, sowie Einrichtungen (c2, c3, D1, R1, 10a, 10b; c2, c3, D1, R1, 10a, 10b, 10c, 10d), fähig die Abstimmung des Resonanzkreises (10) auf die Frequenz fo aufrechtzuerhalten.

11. Magnetometer nach einem der Ansprüche 1 bis 10, dadurch gekennzeichnet, daß es außerdem Einrichtungen (70, 72) umfaßt, fähig den Höchstwert und den Tiefstwert des Polarisationsfeldes jeweils auf Ho und -Ho zu halten.

12. Magnetometer nach einem der Ansprüche 1 bis 11, dadurch gekennzeichnet, daß die zweiten magnetischen Einrichtungen eine Magnetspule (24, 32) umfassen, fähig das Polarisationsmagnetfeld Hb zu erzeugen, daß die Verarbeitungs- und Regeleinrichtungen Einrichtungen (70, 72, 50, 52) zur elektrischen Versorgung dieser Spule umfassen, wobei diese Versorgungseinrichtungen eine Spannungsquelle (70, 72) enthalten, und dadurch, daß die Verarbeitungs- und Regeleinrichtungen außerdem eine Einrichtung (74) enthalten, fähig als Ausgang ein Signal gleich der genannten, zum Feld Hlex proportionalen Spannung (VMes) zu liefern, geteilt durch die Spannung der Quelle (70, 72).

**Claims**

1. Directional resonance magnetometer for measuring a magnetic field H lex, which is the projection, in a given direction (D), of a magnetic field Hex, siad magnetometer comprising:

a sample (2) made from a material having resonant spins,

first magnetic means (4) placed in the vicinity of the sample and which excite the resonance of the spins and for detecting the excited resonance,

second magnetic means (24, 32, 32a, 24a, 24b) placed in the vicinity of the sample and serving to produce a magnetic polarization field Hb in accordance with the predetermined direction and for compensating the field Hlex characterized in that it also has processing and closed loop control means (6, 8, 16, 18, 20 or 22-26-28-30, 36-38-48-50-52 or 38-48-50-52-68; 40, 44) connected to the first magnetic means (4) and to the second magnetic means (24, 32) make it possible to obtain voltage values respectively proportional to (Hb-Ho+Hlex) and to (Ho-Hb+H1ex) in the vicinity of resonance, Ho being the value of the magnetic field applied to the sample at resonance and being well above Hex, and a pulsed square-wave current making it possible to induce the field Hb via second magnetic means (24, 32, 32a, 24a, 24b) and to supply a voltage (Vmes) proportional to said field Hlex.

2. Magnetometer according to claim 1, characterized in that the processing and closed loop control means comprise:

processing means (6, 8, 16, 18, 20 or 22-26-28-30, 36-38-48-50-52 or 38-48-50-52-68) connected to the first magnetic means (4) and to the second magnetic means (24, 32) and making it possible to obtain on the one hand voltage values respectively proportional to (Hb-Ho+H1ex) and to (Ho-Hb+H1ex) in the vicinity of the resonance, Ho being the value of the magnetic field applied to the sample at resonance and being well above Hex, and on the other hand a pulsed square-wave current making it possible to induce the field Hb via second magnetic means (24, 32, 32a, 24a, 24b), and closed loop control means (40, 44) connected on the one hand to the processing means and on the other to the second magnetic means (24, 32, 32a, 24a, 24b) for compensating the field Hlex and which supply a voltage proportional to said field Hlex.

3. Magnetometer according to claim 2, characterized in that the closed loop control means comprise an integrator (40), which is controlled by the latter means, and a voltage-current converter (44), whose input is connected to the integrator output and whose output supplies the second magnetic means (24, 32, 32a, 24a, 24b).

**4.** Magnetometer according to either of the claims 2 and 3, in that the processing means comprise:

electronic means (6, 8, 16, 18, 20) for supplying the first magnetic means (4) by a current at the Larmor frequency corresponding to Ho and for supplying at the output a voltage signal, whose variations as a function of the magnetic field applied to the sample (2) correspond to the dispersion curve of said sample, a first electronic device (36) connected to the output of the electronic means and permitting a voltage gain alternatively +1 and -1, a sample and hold circuit (38), whose input is connected to the output of the first electronic device (36) and whose output controls the closed loop control means (40, 44), a voltage source (48, 70, 72), a second electronic device (50) supplied by said source (48, 70, 72) and permitting a voltage gain of alternatively +1 and -1, and another voltage-current converter (52), whose input is connected to the output of the second electronic device (50) and which supplies the second magnetic means (24, 32, 32a, 24a, 24b).

**5.** Magnetometer according to either of the claims 2 and 3, characterized in that the processing means comprise:

electronic means (6, 8, 16, 18, 22, 26, 28, 30) for supplying the first magnetic means (4) by a current at the Larmor frequency corresponding to Ho and for supplying at the output, due to the controlled synchronous detection by a voltage signal at an audio frequency, a voltage signal, whose variations as a function of the magnetic field applied to the sample (2) correspond to the derivative of the absorption curve of said sample, a first electronic device (36) connected to the output of the electronic means and permitting a voltage gain of alternatively +1 and -1, a sample and hold circuit (38), whose input is connected to the output of the first electronic device (36) and whose output controls the closed loop control means (40, 44), a voltage source (48, 70, 72), a second electronic device (50) supplied by said source (48, 70, 72) and permitting a voltage gain of alternatively +1 and -1, and another voltage-current converter (52), whose input is connected to the output of the second electronic device (50) and which supplies the second magnetic means (24, 32, 32a, 24a, 24b).

**6.** Magnetometer according to either of the claims 2 and 3, characterized in that the processing means comprise:

electronic means (6, 8, 16, 18, 22, 26, 28, 30) for supplying the first magnetic means (4) by a current at the Larmor frequency corresponding to Ho and for supplying at the output, due to the synchronous detection controlled by a voltage signal at an audio frequency, a voltage signal, whose variations as a function of the magnetic field applied to the sample (2) correspond to the derivative of the absorption curve of said sample, a sample and hold circuit (38), whose input is connected to the output of electronic means and whose output controls the closed loop control means (40, 44), a voltage source (48, 70, 72), a summating means (68) for supplying at the output a voltage signal equal to the sum of said voltage and the signal at audio frequency, an electronic device (50) connected to the output of the summating means (68) and permitting a voltage gain of alternatively +1 and -1, and another voltage-current converter (52), whose input is connected to the output of the electronic device (50) and which supplies second magnetic means (24, 32, 32a, 24a, 24b).

**7.** Magnetometer according to any one of the claims 1 to 6, characterized in that the second magnetic means comprise a first magnetic coil (32, 24b) for producing the polarization field Hb and a second magnetic coil (32a, 24a) for compensating the field Hlex, the first and second c oils having the same axis.

**8.** Magnetometer according to either of the claims 5 and 6, characterized in that the second magnetic means comprise a first magnetic coil (24) for producing, in the sample, a magnetic agitation field at the audio frequency, a second magnetic coil (24b) for producing the polarization field Hb and a third magnetic coil (24a) for compensating the field Hlex, the first, second and third coils having the same axis.

**9.** Magnetometer according to either of the claims 5 and 6, characterized in that the second magnetic means comprise a first magnetic coil for fulfilling one of the three functions of producing the polarization field, compensating the field Hlex and producing, in the sample, a magnetic agitation field at the audio frequency, and a second magnetic coil for fulfilling the two other of the said three functions, the first and second coils having the same axis.

10. Magnetometer according to any one of the claims 1 to 9, characterized in that it has a resonant circuit (10), which incorporates the first magnetic means (4) and which is tuned to the resonant frequency fo, as well as means (c2, c3, D1, R1, 10a, 10b; c2, c3, D1, R1, 10a, 10b, 10c, 10d) able to maintain the resonant circuit (10) tuned to the frequency fo.

11. Magnetometer according to any one of the claims 1 to 10, characterized in that it also comprises means (70, 72) able to respectively keep equal to Ho and -Ho the maximum and minimum values of the polarization field.

12. Magnetometer according to any one of the claims 1 to 11, characterized in that the second magnetic means comprise a magnetic coil (24, 32) able to produce a magnetic polarization field Hb, in that the processing and closed loop control means incorporate means (70, 72, 50, 52) for the electrical supply of the said coil, said supply means comprising a voltage cource (70, 72) and in that the processing and closed loop control means also incorporate at least one means (74) able to supply at the output a signal equal to the said voltage (Vmes) proportional to the field Hlex, divided by the voltage of the source (70, 72).

# FIG.1

FIG. 2

FIG. 3

FIG. 4

FIG. 5

FIG. 6

FIG. 7

EP 0 463 919 B1

FIG. 8

22

FIG. 9

FIG. 10

FIG. 11

## FIG. 12

## FIG. 13

FIG. 14

FIG. 20

FIG. 21

FIG. 15

FIG.22

# FIG. 16

# FIG. 17

# FIG. 19

FIG. 18